Europäisches Patentamt

European Patent Office

Office européen des brevets

(11) Veröffentlichungsnummer: **0 108 401**
**A2**

# (12) EUROPÄISCHE PATENTANMELDUNG

(21) Anmeldenummer: 83111004.4

(22) Anmeldetag: 04.11.83

(51) Int. Cl.³: **H 05 K 13/00**

(30) Priorität: 09.11.82 FR 8218780

(43) Veröffentlichungstag der Anmeldung:
16.05.84 Patentblatt 84/20

(84) Benannte Vertragsstaaten:
DE GB IT NL

(71) Anmelder: Deutsche ITT Industries GmbH
Hans-Bunte-Strasse 19 Postfach 840
D-7800 Freiburg(DE)

(84) Benannte Vertragsstaaten:
DE

(71) Anmelder: ITT INDUSTRIES INC.
320 Park Avenue
New York, NY 10022(US)

(84) Benannte Vertragsstaaten:
GB IT NL

(72) Erfinder: Jaeger, Gérard
1, rue des Ancêtres
F-6800 Colmar(FR)

(74) Vertreter: Stutzer, Gerhard, Dr.
Deutsche ITT Industries GmbH Patent- und
Lizenzabteilung Hans-Bunte-Strasse 19 Postfach 840
D-7800 Freiburg(DE)

(54) Magazin für kleine elektronische Bauelemente.

(57) Es wird ein Magazin für kleine elektronische Bauelemente beschrieben, das aus einem rohrförmigen Körper besteht, dessen Hauptteil (2) zu einer Spirale gewunden ist und dessen Endteile (1, 3) sich in Achsrichtung dieser Spirale erstrecken. Der rohrförmige Körper kann um einen Spulenrahmen (6) gewickelt sein, bestehend aus einem Zylinder mit zwei Begrenzungsscheiben (7, 8), an denen jeweil eine Stummelwelle (10,11) angebracht ist. Die Endteile (1, 3) des rohrförmigen Körpers sind durch Öffnungen in den Begrenzungsscheiben (7, 8) heraus und in das Innere der Stummelwellen (10, 11) geführt, die an ihrem jeweiligen Ende Trichteröffnungen (14, 15) aufweisen, zu denen Bohrungen führen, in die die Endteile (1, 3) münden.

EP 0 108 401 A2

0108401

G. Jaeger 1

Fl 1202 EP
Dr. Rl/Be
2. November 1983

## Magazin für kleine elektronische Bauelemente

Die Priorität der Anmeldung Nr. 8218780 vom 9. November 1982 in Frankreich wird beansprucht.

Die Erfindung betrifft ein Magazin, das die Speicherung einer Vielzahl von kleinen elektronischen Bauelementen unter Beibehaltung von deren Orientierung ermöglicht.

Die Erfindung ist von besonderem Interesse für die Speicherung von solchen Dioden, deren Elektroden aus Metallflächen bestehen und die zum direkten Einlöten in gedruckte Schaltungen ausgebildet sind. Diese Dioden bestehen aus einem isolierenden Zylinder, der den Halbleiterkristall enthält und durch zwei Metallteile verschlossen ist, deren Oberflächen als Elektroden dienen. Ein derartiger Zylinder wird zunächst an eine gedruckte Schaltung gebondet, dann durch Schwallöten an der Printplatte befestigt und mit der Schaltung fest verbunden. Die Abmessungen derartiger Dioden betragen z.B. 3 mm Länge und 1,5 mm Durchmesser.

Während der verschiedenen Herstellungs-, Auslieferungs- und Anwendungsstufen umfassen die Chargen im allgemeinen Tausende von Bauelementen. Diese können in Form eines ungeordneten Haufens gespeichert werden, aber vor deren Verwendung ist es erforderlich, daß man die Zylinder nicht nur ausrichtet, sondern auch die Polung der Dioden prüft und diejenigen umdreht, deren Polung nicht mit der gewünschten Richtung übereinstimmt. Man wird verstehen, daß eine Beschickungsvorrichtung, die derartige Maßnahmen bewerkstelligt, sehr teuer ist.

G. Jaeger 1                                    Fl 1202 EP

Deshalb hat man in Betracht gezogen, diese Dioden in Magazinen unterzubringen, die in der häufigsten Form aus einem perforierten oder nichtperforierten Band bestehen, in das die Dioden eingesetzt sind, so daß sie alle einer bestimmten Orientierung folgen. Die Dioden können z.B. in dem Bandeingeklemmt oder verkapselt sein. Obgleich diese Lösung den Vorteil bietet, daß eine der oben genannten teuren Beschickungsvorrichtungen vermieden wird, so liegen die Kosten dennoch hoch, zumal da das Band nicht wieder verwendbar ist. Zusätzlich zu den verhältnismäßig hohen Kosten*das Band muß auch noch für das Einsetzen der Dioden in das Band und das Herausziehen derselben vor der Verwendung gesorgt werden. Deshalb sollte diese Methode auf Produktionszwischenspeicherungen beschränkt bleiben.

Hier setzt nun die Erfindung an. Die Erfindung, wie sie in den Ansprüchen gekennzeichnet ist, löst die Aufgabe, ein billiges, wieder verwendbares Magazin bereitzustellen, das elektronische Bauteile wie z.B. Dioden, auf einfache Weise aufnimmt und speichert, wobei deren Ausrichtung beibehalten wird.

Das Magazin nach der Erfindung besteht aus einem rohrförmigen Körper, durch den die elektronischen Bauteile hindurchgleiten und der sie so führt, daß sie ihre Ausrichtung beibehalten. Dieser rohrförmige Körper ist so aufgewickelt, daß der größte Teil seiner Gesamtlänge in kompakter Form vorliegt.

Gemäß einer Weiterbildung der Erfindung erstrecken sich die Enden des rohrförmigen Körpers entlang einer Achse, um die sein wesentlicher Teil herumgewickelt ist, so daß die Bauelemente an einem festen Punkt entnommen werden können, während sich das Magazin um diese Achse dreht.

* für

Nach einer zusätzlichen Weiterbildung ist der rohrförmige
Körper um eine Vorrichtung gewickelt, die aus ihm eine Spirale
bildet und die aus einem zylindrischen axial ausgerichteten
Körper mit zwei Begrenzungsscheiben besteht, wobei die Enden
des rohrförmigen Körpers durch die beiden Begrenzungsscheiben
geführt sind, so daß sie sich längst der Achse der so gebildeten Aufwickelvorrichtung als Spulenrahmen erstrecken.

In einer zur Speicherung von Dioden vorgesehenen Ausbildungsform, die nachstehend beschrieben wird, besitzt der rohrförmige Körper, im folgenden stets als Rohr bezeichnet, einen
kreisförmigen Querschnitt, der hinreichend groß ist, so daß
die Dioden frei hindurchgleiten können, und dies trotz der
Krümmungen, die sich durch das Aufwickeln auf den Spulenrahmen
ergeben und trotz der Krümmungen, die die Enden des Rohres zur
Achse des Spulenrahmens hin führen.

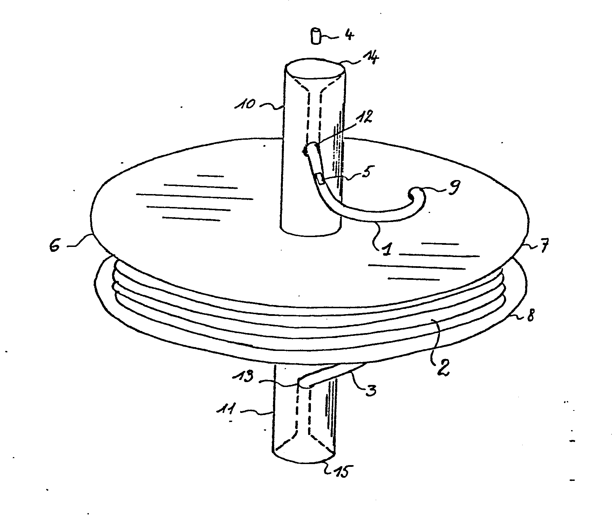

Die Erfindung wird nachstehend an der Figur eines Ausführungsbeispiels näher erläutert.

Wie die Figur zeigt, besteht das Magazin im Prinzip aus einem
Rohr mit den Endteilen 1 und 3 sowie mit dem Hauptteil 2, der
zu einer Spirale gewunden ist.

Die Dioden   sind zylindrische Bauelemente, und der Durchmesser
des Rohres wird im Hinblick auf den der Dioden entsprechen
gewählt, so daß trotz der Krümmungen die Dioden leicht in
dem Rohr gleiten. Das Bezugszeichen 4 in der Figur weist auf
eine solche Diode hin. Darüberhinaus ist das Material des
Rohres so gewählt, daß nur eine minimale Reibung auftritt.
Eine mit einer gegebenen axialen Ausrichtung in das Rohr eingebrachte Diode behält diese beim Durchgleiten des Rohres von
einem Ende zum anderen bei. Das Rohrmaterial darf auch keinen
Metallabtrieb an der Diode bewirken und es dürfen sich keine

G. Jaeger 1                                              Fl 1202 EP

elektrostatischen Ladungen anhäufen, da es sonst zur Zerstörung der Dioden kommen kann. Das Rohrmaterial muß auch ausreichend flexibel ein, damit es die gezeigt Form annimmt und
andererseits ausreichende Steifigkeit besitzt, damit der Querschnitt nicht zusammenfällt. Dieser Anforderung wird durch
die Verwendung eines metallisierten Kunststoffrohres aus z. B.
PVC oder einem anderen Plastikmaterial Genüge getan. Die Verwendung eines transparenten Materials bietet den zusätzlichen
Vorteil, daß man das Füllen des Rohres visuell überprüfen kann.

Um zu einer möglichst großen Längenausdehnung des Rohres zu
kommen, wird dieses vorzugsweise um einen Spulenrahmen 6 gewickelt, und zwar in einer oder mehreren Schichten. Der Spulenrahmen 6 besteht aus zwei Begrenzungsscheiben 7 und 8 und einem
nicht sichtbaren zylindrischen Körper. Diese drei Teile sind
entlang einer gemeinsamen Achse ausgerichtet. Beide Begrenzungsscheiben sind mit Öffnungen versehen, von denen in der
Figur die Öffnung 9 zu erkennen ist, durch die jeweils eines
der Endteile 1, 3 des Rohres verläuft, so daß diese von außerhalb des Spulenrahmens zugänglich sind.

Der Spulenrahmen 6 wird durch eine an ihm angebrachte Welle
vervollständigt, die sich längs seiner Achse erstreckt. In
dem in der Figur gezeigten Ausführungsbeispiel besteht diese
Welle aus zwei identischen zylindrischen Stummelwellen 10, 11,
von denen jede im Zentrum einer der Begrenzungsscheiben 7, 8
sitzt. Die Stummelwellen 10, 11 enthalten jeweils Öffnungen 12,
13, in die die Endteile 1 und 3 des Rohres eingeschoben sind.
Die Endteile 1, 3 enden innerhalb der beiden Stummelwellen
jeweils in axialen Bohrungen, die zu den in den freien Stummelwellenenden liegenden Trichteröffnungen 14, 15 führen,
die ebenfalls symmetrisch zur Achse des Spulenrahmens angeordnet sind. Beide Trichteröffnungen 14, 15 können zum Befestigen
des Spulenrahmens 6 zwischen zwei Punkten verwendet werden,
sie können ferner als Führung für die Dioden, als deren Einlaß
in das Rohr und als Zentriervorrichtung des Rohres im Bezug
auf die Diodenzuführvorrichtung oder Diodenabgabeleitung dienen.

0108401

G. Jaeger 1 Fl 1202 EP

Ist jedoch der Spulenrahmen hinreichend stark genug, so kann die Welle in den Spulenrahmenkörper integriert sein.

Beide Trichteröffnungen 14, 15 sind mit einer nichtgezeigten Kappe ausgefüllt, somit ist die Öffnung an jedem Rohrende verschlossen und die Dioden am Herausfallen aus dem Rohr gehindert.

Aufgrund des Krümmungsradius ist es möglich, das Ende des Rohres, das aus der einen Begrenungsscheibe austritt, nicht zu der trichterförmigen Öffnung der benachbarten Stummelwelle zu führen sondern zu der anderen Öffnung, wobei der Spulenrahmenkörper durchkreuzt wird.

Zusätzlich ist noch zu bemerken, daß ein Spulenrahmen nicht in allen Fällen erforderlich ist. Eine Spule kann durch das Rohr selbst gebildet werden, indem man die einzelnen Wicklungen aneinander fixiert.

Es ist noch anzumerken, daß das eben beschriebene, der Aufnahme von Dioden dienende Magazin auch zur Aufnahme von Bauelementen anderen Typs verwendet werden kann, wenn es in seinen Dimensionen entsprechend angepaßt wird und wenn ein Rohr von entsprechendem Innenquerschnitt Verwendung findet.

Ein Vorteil der Erfindung liegt zunächst in der Lösung der gestellten Aufgabe selbst. Ein weiterer Vorteil liegt darin, daß das Magazin nicht nur zur Speicherung von Bauelementen benutzt werden kann, die an den Anwender ausgeliefert werden, sondern auch im Herstellungswerk zur Zwischenspeicherung von Bauelementen und zum Transport derselben zwischen zwei Produktionsstufen.

Das Füllen des oben beschriebenen Magazins kann leicht über die Schwerkraft erfolgen, indem der Spulenrahmen in geneigter Stellung in langsame Drehung versetzt wird. Bei rascherer Drehung ermöglichen die Zentrifugalkräfte eine leichtere und

G. Jaeger 1                                    Fl 1202 EP

vollständigere Füllung. Andere ins Auge gefaßte Verfahren
zur Verbesserung des Be- und Entladens des Magazins sind z.B.
die Einwirkung  von Schwingkräften (Vibration, Druckluft usw.).

G. Jaeger 1

Fl 1202 EP
Dr. Rl/Be
2. November 1983

Patentansprüche

1. Magazin für kleine elektronische Bauelemente, gekennzeichnet durch einen rohrförmigen Körper mit zu einer Spirale gewundenem Hauptteil (2).

2. Magazin nach Anspruch 1, dadurch gekennzeichnet, daß die Endteile (1, 3) entlang der Achse der Spirale angeordnet sind.

3. Magazin nach einem der Ansprüche 1 oder 2, dadurch gekennzeichnet, daß der rohrförmige Körper um einen Spulenrahmen (6) gewickelt ist, der aus einem zylindrischen Körper und zwei Begrenzungsscheiben (7,8) besteht.

4. Magazin nach Anspruch 3, dadurch gekennzeichnet, daß die Endteile (1, 3) des rohrförmigen Körpers aus den Begrenzungsscheiben (7,8) des Spulenrahmens austreten und längs dessen Achse ausgerichtet sind.

5. Magazin nach Anspruch 4, dadurch gekennzeichnet, daß der Spulenrahmen mit zwei Stummelwellen (10, 11) versehen ist, die eine Halterung und Rotationsbewegung des Spulenrahmens ermöglichen, daß die Endteile (1, 3) jeweils in das Innere eines der Stummelwellen (10, 11) geführt sind und in deren Querschnittsmitte in axialen Bohrungen enden, die zu den jeweils in den freien Stummelwellenenden liegenden Trichteröffnungen (14, 15) führen.

1/1